(19) Europäisches Patentamt / European Patent Office / Office européen des brevets

(11) **EP 4 473 573 B1**

(12) **EUROPEAN PATENT SPECIFICATION**

(45) Date of publication and mention of the grant of the patent:
**25.06.2025 Bulletin 2025/26**

(21) Application number: **23725432.1**

(22) Date of filing: **28.04.2023**

(51) International Patent Classification (IPC):
**H10F 10/16** *(2025.01)*     **H10N 10/00** *(2023.01)*
**H10F 10/174** *(2025.01)*

(52) Cooperative Patent Classification (CPC):
**H10F 10/16; H10F 10/174;** H10K 30/40;
H10N 10/00

(86) International application number:
**PCT/IB2023/054448**

(87) International publication number:
**WO 2024/224151 (31.10.2024 Gazette 2024/44)**

(54) **ADIABATICALLY COOLED HOT CHARGE CARRIER DEVICES**

ADIABATISCH GEKÜHLTE HEISSE LADUNGSTRÄGER-VORRICHTUNGEN

DISPOSITIFS À PORTEURS CHAUDS REFROIDIS ADIABATIQUEMENT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**11.12.2024 Bulletin 2024/50**

(73) Proprietor: **Ceské vysoké ucení technické v Praze 16000 Praha 6- Dejvice (CZ)**

(72) Inventor: **MARKVART, Tom 16627 Prague (CZ)**

(74) Representative: **Poljak, Michal Nove sady 988/2 602 00 Brno (CZ)**

(56) References cited:
WO-A1-2016/090603      FR-A1- 3 048 820
KR-A- 20150 039 520      US-A1- 2013 118 542

- **HUANG HUNG HSIEN ET AL: "Enhanced Seebeck coefficient of bismuth telluride compounds with graded doping profiles", APPLIED PHYSIC LETTERS, 15 October 2013 (2013-10-15), pages 163903 - 1, XP093103125,** Retrieved from the Internet <URL:https://watermark.silverchair.com/163903_1_online.pdf?token=AQECAHi208BE49Ooan9kkhW_Ercy7Dm3ZL_9Cf3qfKAc485ysgAABX8wggV7BgkqhkiG9w0BBwagggVsMIIFaAIBADCCBWEGCSqGSIb3DQEHATAeBglghkgBZQMEAS4wEQQMevNaX2jsobScr7lZAgEQgIIFMs5NEFTPWTkVOnkshMTjPH2aHc9KdNI9NRLTLZjFz18TzrUH18YjR6-SrFC_3Rwow5jgA4o77yRLLofdwBju> [retrieved on 20231118]
- **MARKVART TOM: "Thermodynamics of losses in photovoltaic conversion", APPLIED PHYSICS LETTERS, AMERICAN INSTITUTE OF PHYSICS, 2 HUNTINGTON QUADRANGLE, MELVILLE, NY 11747, vol. 91, no. 6, 7 August 2007 (2007-08-07), pages 64102 - 64102, XP012100576, ISSN: 0003-6951, DOI: 10.1063/1.2766857**
- **GELBSTEIN Y ET AL: "High performance n-type PbTe-based materials for thermoelectric applications", PHYSICA B: CONDENSED MATTER, ELSEVIER, AMSTERDAM, NL, vol. 363, no. 1-4, 15 June 2005 (2005-06-15), pages 196 - 205, XP027836224, ISSN: 0921-4526, [retrieved on 20050615]**

**(Cont. next page)**

- LIMPERT STEVEN ET AL: "A hot carrier solar cell device model using a coupled electron phonon energy balance model", 2013 IEEE 39TH PHOTOVOLTAIC SPECIALISTS CONFERENCE (PVSC), IEEE, 16 June 2013 (2013-06-16), pages 1054 - 1059, XP032568703, DOI: 10.1109/PVSC.2013.6744322
- KONOVALOV IGOR ET AL: "Hot carrier solar cell as thermoelectric device", ENERGY SCIENCE & ENGINEERING, vol. 5, no. 3, 1 June 2017 (2017-06-01), pages 113 - 122, XP093103137, ISSN: 2050-0505, Retrieved from the Internet <URL:https://api.wiley.com/onlinelibrary/tdm/v1/articles/10.1002%2Fese3.159> DOI: 10.1002/ese3.159
- MARKVART TOM: "Can Thermodynamics Guide Us to Make Better Solar Cells?", IEEE JOURNAL OF PHOTOVOLTAICS, IEEE, vol. 9, no. 6, 1 November 2019 (2019-11-01), pages 1614 - 1624, XP011755772, ISSN: 2156-3381, [retrieved on 20191028], DOI: 10.1109/JPHOTOV.2019.2938665
- DASHEVSKY Z ET AL: "Thermoelectric efficiency in graded indium-doped PbTe crystals", JOURNAL OF APPLIED PHYSICS, AMERICAN INSTITUTE OF PHYSICS, 2 HUNTINGTON QUADRANGLE, MELVILLE, NY 11747, vol. 92, no. 3, 1 August 2002 (2002-08-01), pages 1425 - 1430, XP012056976, ISSN: 0021-8979, DOI: 10.1063/1.1490152

## Description

## Technical Field

This invention relates to adiabatically cooled hot charge carrier devices, such as solar cells and thermoelectric elements. This invention further relates to a method for separating charge carriers in such devices.

## Background Art

Within the meaning of this invention, the terms in this paragraph are defined as follows. "Charge carriers" are defined as electrons and holes. "Thermoelectric element" also includes thermoelectric energy converters and generators. "Junction" is understood as an absorber in thin film solar cell terminology and is defined as p-n junction or a region sandwiched between the n- and p-doped regions. "Double heterojunction" is defined as a junction comprising a semiconductor sandwiched between two contact semiconducting materials with different work functions. "Conductivity type" is defined as a property identifying the majority charge carrier in a semiconductor material (i. e. electrons in n-type and holes in p-type).

The operation of solar cells is based on photovoltaic energy conversion (see e. g. the handbook by Tom Markvart titled "Solar Electricity"). The conversion process consists of the creation of mobile charge carriers (electrons and holes) by light, followed by their separation at a junction, and collection at contacts to produce electrical current and voltage at the cell terminals. When created by light the charge carriers have a substantially higher energy than the semiconductor bandgap: in thermodynamic terms, they are hot. During the charge separation and collection to contacts, this extra energy is lost when the carriers are cooled to the temperature of the contacts. This is a significant energy loss which is present in all solar cells that have been made to-date. Unless special precautions are taken, this cooling (also called thermalization) occurs rapidly, before charges are separated at the junction.

Thermoelectric elements exploit the temperature difference between two heat sources to generate electricity. The element typically comprises two materials which - when connected together - form two junctions. Exposure of one junction to a high temperature source, the other to a cold source, generates electrical current in the circuit. A variety of materials can be used to manufacture thermoelectric elements; semiconductors are among the most popular due to their high efficiency. The two parts of the junction can then be made of the same semiconductor but each alloyed or doped with different impurities. There is a similarity with the operation of solar cells and thermoelectric elements, with the key difference that the charge carriers are generated at the junction by heat. Keeping the junction at an elevated temperature brings the junction to equilibrium at this temperature and leads directly to charge separation. These charge carriers then have to be cooled to the temperature of the contacts. This process is similar to the cooling of photogenerated charge carriers in a solar cell and leads to similar loss.

Separation of charge carriers at the junction is a common feature of thermoelectric elements and solar cells alike. In the former case, the carriers are generated by heat, in the latter, by light. Losses often as high as 50 % or even higher occur between this first event and energy collection at the contacts, during the cooling of the charge carriers from the temperature of the hot source to being removed at the cold junction or contacts (i. e. thermalization). The cooling of carriers in the course of power generation in both thermoelectric elements and solar cells is inefficient as it is thermodynamically irreversible.

The publication by Ross and Nozik titled "Efficiency of hot-carrier solar energy converters" (1982) discloses a single-threshold quantum-utilizing device in which the excited carriers thermally equilibrate among themselves, but not with the environment, thus converting solar energy with an increased efficiency achieved through removing hot carriers from the absorber at a specific energy (or in a very narrow energy range) via the so-called selective energy contacts. These selective energy contacts are claimed to cool carriers to the contact temperature whilst retaining a large part of the heat gained in the absorption process.

The publication by Ferry et al. titled "Challenges, myths, and opportunities in hot carrier solar cells" (2020) proposes another structure for hot carrier solar cells, comprising $In_{0.53}Ga_{0.47}As$ absorber layer and $GaAs_{0.51}Sb_{0.49}$ extraction layer.

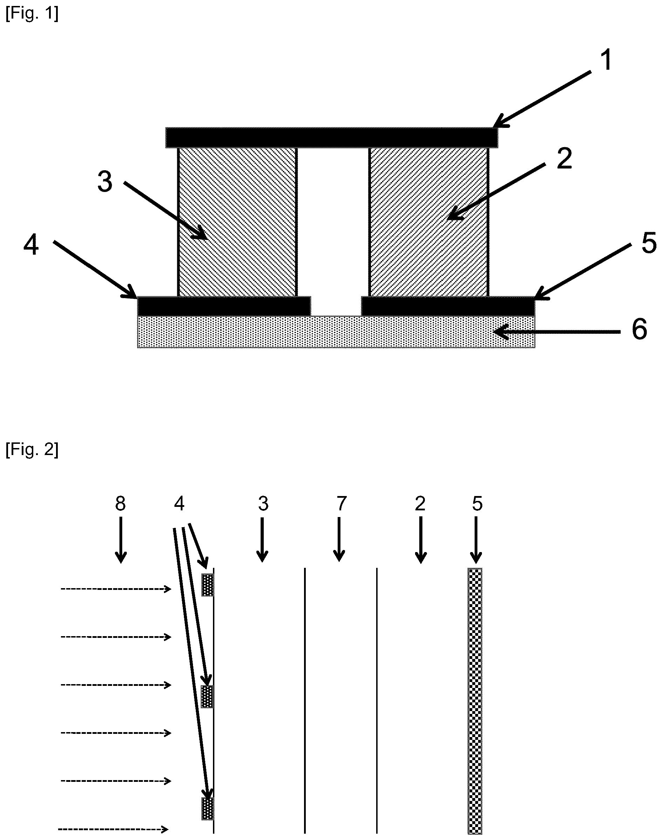

The international patent application WO 2012006223 A2 describes efficiency loss mechanisms in a solar cell (see Fig. 1 of this prior art document) and aims to solve these losses by alternating bias hot carrier solar cells.

The US patent US 9842957 B1 discloses a solar cell design featuring p-or-n type GaAs with alternating p-n junction regions on the back-surface of the cell, opposite incident solar irradiance. Various layers of p-or-n type GaAs are interfaced together to collect charge carriers, and a thin window layer of AlGaAs is applied to the front and back surfaces to prevent recombination of charge carriers.

Rosenwaks et al. (Physical review B, vol. 48, no. 19, 1993) further describes slower hot-electron cooling rates for GaAs quantum wells in comparison to bulk GaAs due to an enhanced hot-phonon-bottleneck effect in quantum wells at photogenerated carrier densities above high-$10^{17}$ to low-$10^{18}$ cm$^{-3}$ values.

The publication Konovalov et al. (Energy Science & Engineering, vol. 5, no. 3, p. 113-122, 2017) discloses a charge carrier separation device for adiabatic cooling of hot charge carriers. The device comprises a first n-type semiconductor doped region (n-ZnO) and a second p-type semiconductor doped region (p-ZnTe). The regions are separated by a junction (i-PbSe) susceptible upon heating or illumination to creation of positively charged and negatively charged mobile charge carriers. The first n-type semiconductor doped region is further connected to a negative electric contact for collecting the negatively charged mobile charge carriers and the second p-type semiconductor doped region is further connected to a positive electric contact for collecting the positively charged mobile charge carriers. Each region thus has a junction end and a contact end, and the junction thus has an n-side and a p-side. The publication also aims at thermodynamical reversibility of the processes involved in the operation of the device, provided that the donor dopant density is uniform.

A similar device is disclosed in the publication Markvart (IEEE Journal of Photovoltaics, vol. 9, no. 6, p. 1614-1624, 2019), also aiming at thermodynamical reversibility of the processes involved in the operation of the device, provided that the donor dopant density is uniform.

The publication Dashevsky et al. (Journal of Applied Physics, vol. 92, no. 3, p. 1425-1430, 2002), the international patent application WO 2016090603 A1 and the Korean patent application KR 20150039520 A all disclose that a graded concentration of dopants in general, following the temperature gradient along the legs of a thermoelectric device improves its efficiency.

The present invention aims to alleviate or remove the loss during carrier cooling, by making the cooling process thermodynamically reversible. According to the general laws of thermodynamics, reversibility of the process ensures that these losses can be reduced to their theoretical minimum.

The object of the present invention is to provide a device and a method for alleviating or removing said loss during carrier cooling.

## Summary of Invention

In the first aspect of this invention, the object of the present invention is achieved by a charge carrier separation device for adiabatic cooling of hot charge carriers, according to claim 1, the device comprising a first n-type semiconductor doped region and a second p-type semiconductor doped region. These regions are separated by a junction susceptible upon heating or illumination to creation of positively charged and negatively charged mobile charge carriers. The first n-type semiconductor doped region is further connected to a negative electric contact for collecting the negatively charged mobile charge carriers and the second p-type semiconductor doped region is further connected to a positive electric contact for collecting the positively charged mobile charge carriers. Each region thus has a junction end and a contact end, and the junction thus has an n-side and a p-side.

The first n-type semiconductor doped region comprises a non-uniform doping profile in which the donor dopant density $N_D(x_n)$ at a distance $x_n$ measured from the junction end of the first n-type semiconductor doped region towards the negative electric contact varies according to the equation

$$N_D(x_n) = \mathrm{N}_D(0)\left\{\frac{\mathrm{T}_n(\mathrm{x}_n)}{T_h}\right\}^{\frac{3}{2}},$$

where $N_D(0)$ is a donor doping density at the junction end of the first n-type semiconductor doped region where $x_n = 0$; $T_n(x_n)$ is a charge carrier temperature at a distance $x_n$ measured from the junction end of the first n-type semiconductor doped region towards the negative electric contact; and $T_h$ is a charge carrier temperature at the junction end of the first n-type semiconductor doped region where $x_n = 0$, $T_h$ being higher than $T_n$. The maximum value of $x_n$ is equal to the thickness $d_n$ of the first n-type semiconductor doped region and the charge carrier temperature $T_n(d_n)$ is the equilibrium carrier temperature $T_o$ equal to the temperature of the contact. The donor dopant density $N_D(x_n)$ is hence a function of the charge carrier temperature $T_n(x_n)$, which in turn is a function of the distance $x_n$ from the n-side of the junction. Importantly, the ratio of $N_D(x_n)$ to $T_n(x_n)^{3/2}$ remains constant along the function, thus satisfying the condition of keeping the thermopower and charge carrier entropy constant throughout the first n-type semiconductor doped region. The equation in this paragraph corresponds to a general variation of the temperature profile in the first n-type semiconductor doped region.

The second p-type semiconductor doped region comprises a non-uniform doping profile in which the acceptor dopant density $N_A(x_p)$ at a distance $x_p$ measured from the junction end of the second p-type semiconductor doped region towards the positive electric contact varies according to the equation

$$N_A(x_p) = \mathrm{N}_A(0)\left\{\frac{\mathrm{T}_p(\mathrm{x}_p)}{T_h}\right\}^{\frac{3}{2}},$$

where $N_A(0)$ is an acceptor doping density at the junction end of the second p-type semiconductor doped region where $x_p = 0$; $T_p(x_p)$ is a charge carrier temperature at a distance $x_p$ measured from the junction end of the second p-type semiconductor doped region towards the positive electric contact; and $T_h$ is a charge carrier temperature at the junction end of the second p-type semiconductor doped region where $x_p = 0$, $T_h$ being higher than $T_p$. The maximum value of $x_p$ is equal to the thickness $d_p$ of the second p-type semiconductor doped region and the charge carrier temperature $T_p(d_p)$ is the equilibrium carrier temperature $T_o$ equal to the temperature of the contact. The acceptor dopant density $N_A(x_p)$ is hence a function of the charge carrier temperature $T_p(x_p)$, which in turn is a function of the distance $x_p$ from the p-side of the junction. Importantly, the ratio of $N_A(x_p)$ to $T_p(x_p)^{3/2}$ remains constant along the function, thus satisfying the condition of keeping the thermopower and charge carrier entropy constant throughout the second p-type semiconductor doped region. The equation in this paragraph corresponds to a general variation of the temperature profile in the second p-type semiconductor doped region.

In the second aspect of this invention, the object of the present invention is achieved by a charge carrier separation device for adiabatic cooling of hot charge carriers, according to claim 2, the device comprising a first n-type semiconductor doped region and a second p-type semiconductor doped region. These regions are separated by a junction susceptible upon heating or illumination to creation of positively charged and negatively charged mobile charge carriers. The first n-type semiconductor doped region is further connected to a negative electric contact for collecting the negatively charged mobile charge carriers and the second p-type semiconductor doped region is further connected to a positive electric contact for collecting the positively charged mobile charge carriers. Each region thus has a junction end and a contact end, and the junction thus has an n-side and a p-side.

The first n-type semiconductor doped region comprises a non-uniform doping profile in which the donor dopant density $N_D(x_n)$ at a distance $x_n$ measured from the junction end of the first n-type semiconductor doped region towards the negative electric contact varies according to the equation

$$N_D(x_n) = N_D(0)\left\{1 - \frac{x_n}{d_n}\left(1 - \frac{T_o}{T_h}\right)\right\}^{\frac{3}{2}},$$

where $N_D(0)$ is a donor doping density at the junction end of the first n-type semiconductor doped region where $x_n = 0$; $d_n$ is a distance measured between the junction end of the first n-type semiconductor doped region and the negative electric contact where $x_n = \max$ (i. e. $d_n$ corresponding to the maximum value of $x_n$); $T_o$ is a charge carrier temperature measured at the contact end of the first n-type semiconductor doped region where $x_n = d_n$; and $T_h$ is a charge carrier temperature at the junction end of the first n-type semiconductor doped region where $x_n = 0$, $T_h$ being higher than $T_o$. The donor dopant density $N_D(x_n)$ is hence a function of the charge carrier temperature proportional to $T(x_n)^{3/2}$, which in turn is a function of the distance $x_n$ from the n-side of the junction. The equation in this paragraph corresponds to a linear variation of the temperature profile in the first n-type semiconductor doped region, linearized in the form of

$$T(x_n) = T_h - x_n \cdot \frac{T_h - T_o}{d_n} .$$

In particular, the ratio of $N_D(d_n)/N_D(0)$ is equal to $\left(\frac{T_o}{T_h}\right)^{3/2}$, ondition of keeping the thermopower and charge carrier entropy constant across the first n-type semiconductor doped region can be satisfied.

The second p-type semiconductor doped region comprises a non-uniform doping profile in which the acceptor dopant density $N_A(x_p)$ at a distance $x_p$ measured from the junction end of the second p-type semiconductor doped region towards the positive electric contact varies according to the equation

$$N_A(x_p) = N_A(0)\left\{1 - \frac{x_p}{d_p}\left(1 - \frac{T_o}{T_h}\right)\right\}^{\frac{3}{2}},$$

where $N_A(0)$ is an acceptor doping density at the junction end of the second p-type semiconductor doped region where $x_p = 0$; $d_p$ is a distance measured between the junction end of the second p-type semiconductor doped region and the positive electric contact where $x_p = \max$ (i. e. $d_p$ corresponding to the maximum value of $x_p$); $T_o$ is a charge carrier temperature measured at the contact end of the second p-type semiconductor doped region where $x_p = d_p$; and $T_h$ is a charge carrier temperature at the junction end of the second p-type semiconductor doped region where $x_p = 0$, $T_h$ being higher than $T_o$. The acceptor dopant density $N_A(x_p)$ is hence a function of the charge carrier temperature $T(x_p)^{3/2}$, which in turn is a function of the distance $x_p$ from the p-side of the junction. The equation in this paragraph corresponds to a linear variation of the temperature profile in the second p-type semiconductor doped region, linearized in the form of

$$T\left(x_p\right) = T_h - x_p \cdot \frac{T_h - T_0}{d_p} \, .$$

In particular, the ratio of $N_A(d_p) / N_A(0)$ is equal to $\left(\frac{T_0}{T_h}\right)^{3/2}$, and te condition of keeping the thermopower and charge carrier entropy constant across the second p-type semiconductor doped region can be satisfied.

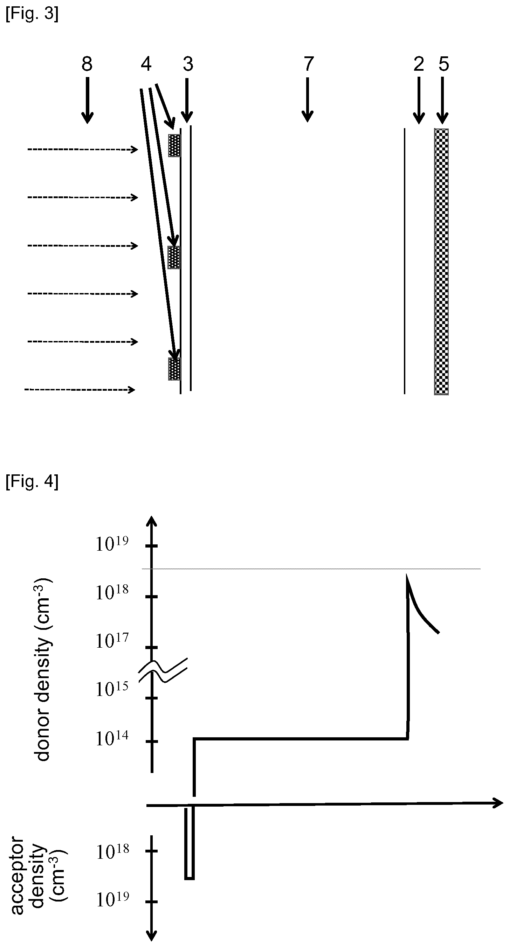

The charge carrier temperature $T_h$ at the junction ends can be measured directly in a thermoelectric converter or determined by photoluminescence under illumination at the same level as under operation, for a sample representing a layer of the junction material sandwiched between two layers doped to dopant densities $N_D(0)$ and $N_A(0)$. The publications Lyeo et al. (Science, Feb. 6, 2004, New Series, Vol. 303, No. 5659, Mathematics in Biology, pp. 816-818, see especially page 816, equation 1 and fig. 2) and Kim et al. (Appl. Phys. Lett. 90, 043107 (2007), see especially equations 3 and 4 and fig. 4) describe how such charge carrier temperature $T_h$ at the junction ends can be measured before determining the doping profile and fabricating the device. The charge carrier temperature $T_o$ at the contact ends can be measured by conventional means.

Energy conversion hot-carrier devices rely on hot carrier cooling via an adiabatic process - in other words, a process where the total energy is conserved in the cooling process. In the present invention, such adiabatic cooling is achieved in a thermodynamic process akin to thermoelectricity, by variable doping density in the semiconductors where the carriers are cooled, as shown above.

In a thermodynamic system, an adiabatic process is such where the carrier entropy remains constant. It is shown in standard texts on thermodynamics [e. g. H. B. Callen, Thermodynamics and an Introduction to Thermostatistics, Wiley, New York (1985)] that the carrier entropy in semiconductors is equal to thermoelectric power (abbreviated as thermopower) or Seebeck coefficient of the carrier multiplied by the carrier charge. In an adiabatic cooling process, the carrier thermopower therefore remains constant.

The present invention exploits the fact that the carrier thermopower depends on both the temperature and the carrier density. The requirement that the thermopower is constant therefore defines a functional relationship of $n = f(T)$ between the temperature $T$ and the carrier density $n$ during the device operation. The function $f(T)$ depends on the materials and whether the material is of n- or p-type. In general, the function $f(T)$ can be obtained experimentally by measuring the thermopower as a function of both the dopant density and the temperature [e. g. as performed by G. Homm et al., Seebeck coefficient of n-type (Ga,In)(N,As), (B,Ga, In)As and GaAs, Appl. Phys. Lett. 93, 042107 (2008) or by K. Kim et al, Thermopower profiling of a silicon p-n junction, Appl. Phys. Lett. 90, 043107 (2007)]. The situation becomes simpler in many semiconductors where the thermopower $\varepsilon$ can be written as

$$\varepsilon = \frac{k_B}{q} ln\left(\frac{T^{3/2}}{n}\right) + constant$$

where $k_B$ is the Boltzmann constant and q is the carrier charge [see A. F. Ioffe, Semiconductor Thermoelements and Thermoelectric Cooling, Infosearch Ltd. London, 1957]. The relationship between carrier density and temperature which determines the adiabatic cooling process then takes on the simple form

$$n = constant * T^{3/2} .$$

In a doped region, the thermopower will be dominated by the majority carriers, and the carrier density can be set qual to the acceptor or donor density $N_A$ or $N_D$.

According to an embodiment of the invention, the device is a thermoelectric element, wherein the junction is a metal junction, and the positive and negative electric contacts are further connected to a heat sink.

According to an embodiment of the invention, the device is a solar cell, preferably hot carrier solar cell, wherein the junction is a semiconductor junction, and the device can further comprise an optical focusing means for guiding light onto the junction, such as a lens.

The present invention therefore describes a thermoelectric device or a solar cell where the doping densities in the n- and p-type regions on either side of the absorber / junction are equal to $N_D = f_n(T)$ and $N_A = f_p(T)$, where $f_n(T)$ and $f_p(T)$ are the function $f(T)$ for the n- and p-type materials, which can be determined experimentally for any specific material. The temperature at the contacts can be easily measured by conventional methods and the temperature at the junction can be measured by manufacturing a similar model device with an identical junction and identical doping densities of the n- and p-regions at junction ends and by measuring the temperature at the junction under intended illumination.

The principle of operation of the devices as described above is as follows. Carriers are generated by absorption of light or by heat directly inside the junction. Importantly, the junction is subject to a strong electric field. Such strong electric field leads to a rapid separation of the charge carriers, before they can lose a significant part of the energy acquired from light or temperature difference.

The charge carriers photogenerated by light in a solar cell, or by heat in a thermoelectric element, which are separated to the edges of the junction then retain a substantial portion or all of their high initial energy. The next step - carrier cooling whilst being transported to contacts - is the essential step of this invention. In conventional solar cells and thermoelectric elements, this cooling takes place at a constant carrier density - in other words, constant volume per charge carrier. Such an isochoric process is thermodynamically irreversible and implies losses which cannot be avoided at the fundamental level.

The devices according to the invention will carry out this cooling adiabatically. In thermodynamic terms this means that the entropy of each charge carrier remains constant during the cooling process. It also means that the charge carriers retain the initial energy after charge separation at the junction. Since the carrier entropy divided by the carrier charge is equal to the Seebeck coefficient (or thermoelectric power), the Seebeck coefficient of carriers on either side of the junction remains constant during the cooling process. It is the non-uniform doping profiles of the first n-type and/or the second p-type semiconductor doped regions as described by the above equations that results in such adiabatic and thermodynamically reversible cooling.

The non-uniform doping profile in the first n-type and the second p-type regions at the junction end creates an electric field and an electrostatic potential which varies with position. With the doping profile given by the above-cited equations, the electrostatic energy of each carrier (electrons and holes) increases as they move away from the junction. The adiabatic cooling then means that the thermal energy which the carriers possess near the junction, is gradually converted into electrostatic energy as they move towards the contacts. This electrostatic energy is then added to the voltage that would be generated as part of the conventional photovoltaic conversion. This increase will depend on the energy of the bandgap.

Preferably, the donor doping density $N_D(0)$ and the acceptor doping density $N_A(0)$ of the device described herein can range from $10^{18}$ to $10^{20}$ cm$^{-3}$. The doping density higher than $10^{18}$ cm$^{-3}$ creates a high electric field in the junction and at junction ends of the regions, while the doping density lower than $10^{20}$ cm$^{-3}$ avoids adverse heavy doping effects such as bandgap narrowing.

Preferably, the junction can be intrinsic (i. e. PIN junction) or doped to an n- or p-conductivity type. An intrinsic junction stretches band where light is absorbed and still provides a sufficiently strong electric field despite a mild weakening. If both semiconductor regions are doped, care needs to be taken to keep the junction sufficiently wide to absorb enough light. If only one semiconductor region is doped, the junction can be wider.

Preferably, the junction can be a single heterojunction, e. g. comprising GaAs. The GaAs heterojunction can be doped to an n-conductivity type and coupled at its p-side with the second p-type semiconductor doped region comprising a $Ga_xAl_{1-x}As$ window layer having p-conductivity type, and coupled at its n-side with the first n-type semiconductor doped region comprising a GaAs layer having n-conductivity type, as described in Zhang et al., "A review on thermalization mechanisms and prospect absorber materials for the hot carrier solar cells", Solar Energy Materials & Solar Cells 225 (2021) 111073. The donor dopants can be selected from silicon, tin, selenium, tellurium and sulfur, and the acceptor dopants are selected from zinc, beryllium, cadmium, magnesium and carbon (see US 9842957 B1).

Preferably, the junction can be a double heterojunction, e. g. comprising a semiconductor having a perovskite structure, preferably $CH_3NH_3PbI_3$ as described in Zhang et al., "A review on thermalization mechanisms and prospect absorber materials for the hot carrier solar cells", Solar Energy Materials & Solar Cells 225 (2021) 111073, sandwiched between a doped electron transporting layer, preferably $TiO_2$ doped with nitrogen as described in Asahi et al., "Nitrogendoped titanium dioxide as visible-light-sensitive photocatalyst: designs, developments, and prospects", Chem. Rev. 19 (2014) 9824, and a doped hole transporting layer, preferably CuI doped with sulfur as described in Ahn et al., "Highly Conductive p-type transparent conducting electrode with sulfur-doped copper iodide", Chem. Mater. 34 (2022) 10517.

Preferably, the thickness of the junction can range from 100 nm to 10 $\mu$m. It holds that the narrower the junction, the stronger the electric field formed in the junction, and that the wider the junction, the more light it can absorb.

In the third aspect of this invention, the object of the present invention is achieved by a method for separating mobile charge carriers in the solar cell as described above, according to claim 13, comprising the steps of:

a. illuminating the junction by light, thereby creating positively charged and negatively charged mobile charge carriers;
b. allowing to separate said negatively charged mobile charge carriers to the n-side of the junction and said positively charged mobile charge carriers to the p-side of the junction by means of electric field, wherein said mobile charge carriers have a charge carrier temperature $T_h$ at the respective side of the junction;
c. transporting said negatively charged mobile charge carriers from the junction end towards to the contact end of the first n-type semiconductor doped region and said positively charged mobile charge carriers from the junction end towards to the contact end of the second p-type semiconductor doped region, thus adiabatically cooling said mobile charge carriers; and

d. collecting said negatively charged mobile charge carriers at the contact end of the first n-type semiconductor doped region and said positively charged mobile charge carriers at the contact end of the second p-type semiconductor doped region.

In the fourth aspect of this invention, the object of the present invention is achieved by a method for separating mobile charge carriers in the thermoelectric element as described above, according to claim 14, comprising the steps of:

a. heating the junction, thereby creating positively charged and negatively charged mobile charge carriers having a charge carrier temperature $T_h$;

b. allowing to separate said negatively charged mobile charge carriers to the n-side of the junction and said positively charged mobile charge carriers to the p-side of the junction by means of electric field, wherein said mobile charge carriers have a charge carrier temperature $T_h$ at the respective side of the junction;

c. transporting said negatively charged mobile charge carriers from the junction end towards to the contact end of the first n-type semiconductor doped region and said positively charged mobile charge carriers from the junction end towards to the contact end of the second p-type semiconductor doped region, thus adiabatically cooling said mobile charge carriers; and

d. collecting said negatively charged mobile charge carriers at the contact end of the first n-type semiconductor doped region and said positively charged mobile charge carriers at the contact end of the second p-type semiconductor doped region.

**Brief Description of Drawings**

**Fig.1**
[Fig.1] shows a schematic arrangement of a thermoelectric element.

**Fig.2**
[Fig.2] shows a schematic arrangement of a solar cell.

**Fig.3**
[Fig.3] shows another schematic arrangement of a solar cell.

**Fig.4**
[Fig.4] shows a graph of donor and acceptor doping densities $N_D(x_n)$ and $N_A(x_p)$ as a function of distance $x_n$, or $x_p$ respectively.

**Fig.5**

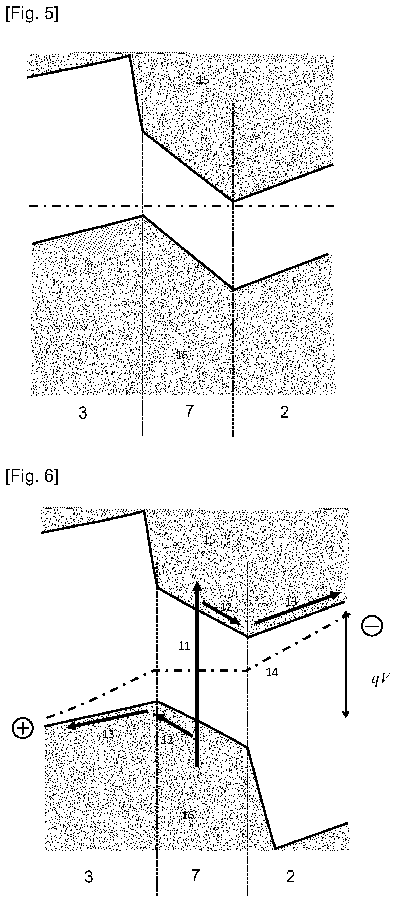

[Fig.5] shows a band diagram of a single heterojunction of a solar cell at equilibrium.

**Fig.6**
[Fig.6] shows a band diagram of a single heterojunction of a solar cell under illumination.

**Fig.7**

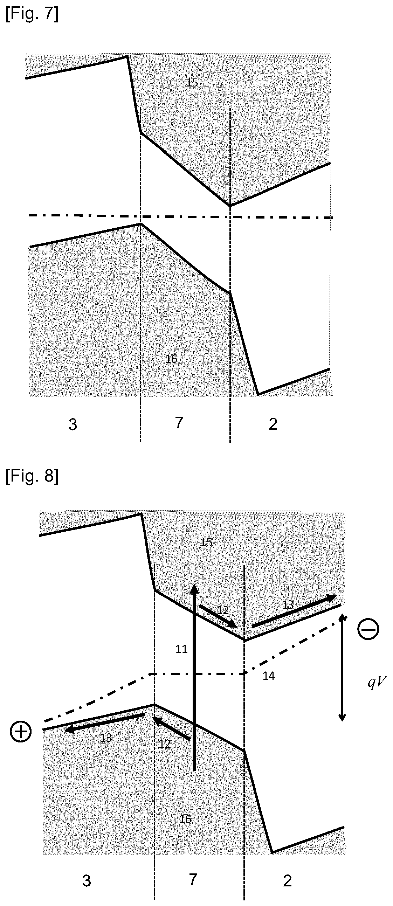

[Fig.7] shows a band diagram of a double heterojunction of a solar cell at equilibrium.

**Fig.8**
[Fig.8] shows a band diagram of a double heterojunction of a solar cell under illumination.

**Fig.9**

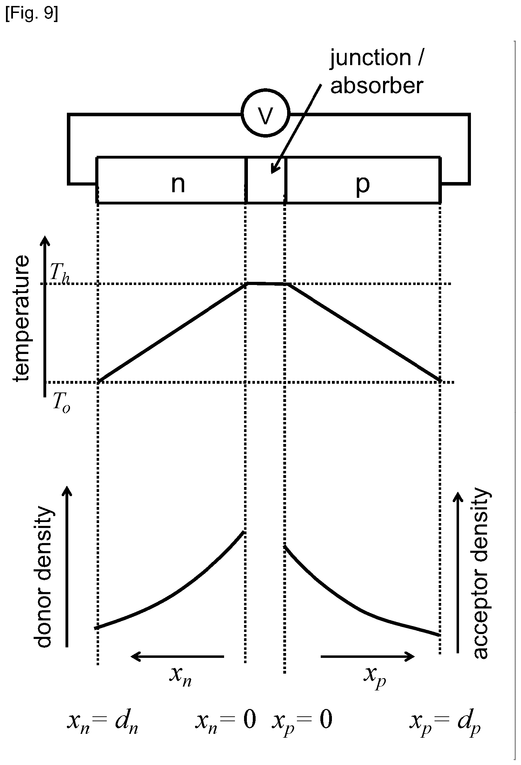

[Fig.9] shows the charge carrier temperatures $T_n(x_n)$ and $T_p(x_p)$ as a function of the distance $x_n$, or $x_p$ respectively (top) and the donor and acceptor dopant densities $N_D(x_n)$ and $N_A(x_p)$ as a function of the distance $x_n$, or $x_p$ respectively (bottom).

**Examples**

Example 1

All the thermoelectric elements in this invention have the general structure shown in Fig. 1. The thermoelectric element comprises a first n-type semiconductor doped region 2 and a second p-type semiconductor doped region 3. The regions 2, 3 are separated by a metal junction 1 susceptible upon heating to creation of positively charged and negatively charged mobile charge carriers. The first n-type semiconductor doped region 2 is further connected to a negative electric metal contact 5 for collecting the negatively charged mobile charge carriers (electrons) and the second p-type semiconductor doped region 3 is further connected to a positive electric metal contact 4 for collecting the positively charged mobile charge carriers (holes). Each region 2, 3 thus has a junction end and a contact end and the junction 1 thus has an n-side and a p-side. The positive and negative electric contacts 4, 5 are further connected to a heat sink 6. The first n-type semiconductor doped region 2 comprises a non-uniform doping profile as explained above (e. g. corresponding to claim 1 or 2). Alternatively, or in addition to that, the second p-type semiconductor doped region 3 comprises a non-uniform doping profile as explained above (e. g. corresponding to claim 1 or 2). The temperature function and the dopant density function can be seen in Fig. 9.

Example 2

Similarly, all the solar cells in this invention have the general structure shown in Fig. 2. The solar cell comprises a first n-type semiconductor doped region 2 and a second p-type semiconductor doped region 3. The regions 2, 3 are separated by a semiconductor junction 7 susceptible upon illumination to creation of positively charged and negatively charged mobile charge carriers. The first n-type semiconductor doped region 2 is further connected to a negative electric metal contact 5 for collecting the negatively charged mobile charge carriers (electrons) and the second p-type semiconductor doped region 3 is further connected to a positive electric metal contact 4 for collecting the positively charged mobile charge carriers (holes). Each region 2, 3 thus has a junction end and a contact end and the junction 1 thus has an n-side and a p-side. The solar cell further comprises an optical focusing means for guiding light onto the junction 7. The first n-type semiconductor doped region 2 comprises a non-uniform doping profile as explained above (e. g. corresponding to claim 1 or 2). Alternatively, or in addition to that, the second p-type semiconductor doped region 3 comprises a non-uniform doping profile as explained above (e. g. corresponding to claim 1 or 2). The temperature function and the dopant density function can be seen in Fig. 9.

Example 3

Regarding Fig. 2, the structure is shown with the p-type region 3 as the top layer (the layer onto which the light is incident) and the n-type region 2 as the bottom layer but the reverse arrangement (the n-type region 2 being the top layer and the p-type region 2 being the bottom layer) is also possible.

The top layer (in Fig. 2, the second p-type semiconductor doped region 3, but this also applies to the thermoelectric element of Fig. 1) represents a semiconductor with a non-uniform doping profile to allow adiabatic cooling (as discussed above), of holes in this particular arrangement, with a high dopant density at the junction end. It can be made of a wide-bandgap semiconductor to allow most of the incident light to pass through. The requirement of minimum absorption and adiabatic cooling (to be discussed below, in the section describing the bottom layer of the structure) therefore means that this layer is preferably thin and, wherever possible, made of an indirect bandgap semiconductor. The wide-bandgap semiconductors are normally chosen by lattice matching to the adiabatic cooling layer underneath. This means, most likely (assuming that the materials discussed in Zhang et al. are covered) binary, ternary or quaternary alloys of Al, Ga and/or In with P, As and/or Sb. A number of these semiconductors have both a high bandgap and an indirect bandgap (for such materials, see also Bett et al., "III-V compounds for solar cell applications", 1999).

The middle layer (in Fig. 2, the semiconductor junction 7) is intended to absorb most or all of the incident light, and its thickness $d_{abs}$ should therefore satisfy the relation $\alpha.d_{abs} > 1$, where $\alpha$ is the typical absorption coefficient of the absorber layer (the junction 7). For most direct gap semiconductors, $\alpha$ is of the order of $10^4$ cm$^{-1}$ and the thickness of the junction 7 can therefore be of the order of 1 $\mu$m.

This absorber layer can be lightly doped and, by being sandwiched between highly doped n- and p-type layers, it represents a junction in the sense that it contains a strong electric field. If $\Delta F_n$ and $\Delta F_p$ are the separations of the Fermi levels on the n- and p-side of the junction from their respective band edges, this electric field will be equal to $(E_g - \Delta F_n - \Delta F_p)/qd_{abs}$ , where $E_g$ is the bandgap of the absorber / junction semiconductor and q is the electron charge. For typical materials in question, this electric field will therefore be of the order of kV/cm. Basic junction theory [e. g. S. M. Sze and k. Ng. Kwok, Physics of Semiconductor Devices, 3rd ed., John Wiley and Sons, 2007] leads to the conclusion that a uniform electric field in this region requires the doping to be below $2^*\varepsilon(E_g - \Delta F_n - \Delta F_p)/qd_{abs}^2$, where $\varepsilon$ is the dielectric constant of the absorber / junction semiconductors.

The junction 7 can be made from a semiconductor with long cooling time (denoted here by $\tau_{cool}$) for the hot

photogenerated carriers. If $\tau_t$ is the carrier transit time through the junction 7, then $\tau_t = d_{abs}/v$, where $v$ is the carrier velocity in the electric field of the junction 7. Efficient charge separation of the hot carriers therefore requires that $\tau_t < \tau_{cool}$. The carrier velocity v in strong electric fields is typically of the order of $10^7$ cm/sec [e. g. T. Markvart and L. Castañer, Practical handbook of Photovoltaics, Elsevier, 2003]. Semiconductors that fulfil this requirement will therefore need to have the cooling time $\tau_{cool}$ of the order of 10 ps or longer. A number of such materials exists and are discussed in Zhang et al., "A review on thermalization mechanisms and prospect absorber materials for the hot carrier solar cells", Solar Energy Materials & Solar Cells 225 (2021) 111073.

The junction 1 of the thermoelectric element can be made of metal.

The bottom layer (in Fig. 2, the first n-type semiconductor doped region 2, but this also applies to the thermoelectric element of Fig. 1) can be made of a semiconductor with a non-uniform doping profile to allow adiabatic cooling (as discussed above), of electrons in this particular arrangement. Similar to the junction layer, this layer can be made of material with long carrier (in this situation, electron) cooling time, but it will be doped to higher doping density, with a non-uniform (graded) doping profile. The doping density is preferably above $10^{18}$ cm$^{-3}$ to create a high electric field in the junction layer and preferably below $10^{19}$ or below $10^{20}$ cm$^{-3}$ to avoid adverse heavy doping effects, such as bandgap narrowing.

On account of the non-uniform doping density, both regions 2, 3 contain an electric field but this field is relatively weak, and its effects on transport are largely compensated by the temperature gradient. One can therefore assume that the predominant mode of carrier transport in these regions is by diffusion. During the cooling time $\tau_{cool}$, a carrier with diffusion constant D will diffuse a distance $d_{diff} = (D . \tau_{cool})^{1/2}$. With a cooling time of 10 ps, this places a requirement on the thickness of adiabatic cooling region $d_{ad}$ to be $d_{diff} > d_{ad}$, where $d_{ad}$ is equal to $d_n$ or $d_p$, as appropriate. Taking a diffusion constant D to be of the order of 10 cm$^2$/s (see e. g. T. Markvart and L. Castañer, Practical handbook of Photovoltaics, Elsevier, 2003) gives the maximum thickness of the adiabatic cooling regions of the order of 0.1 $\mu$m. The value of D used is probably an underestimate as there are indications [E. Najafi et al., Super-diffusion of excited carriers in Semiconductors, Nature Com. 8:15177, 2017; and Q. Weng et al., Quasiadiabatic electron transport in room temperature nanoelectronic devices induced by hot-phonon bottleneck, Nature Com., 12:4752, 2021] that the diffusion constant of hot carriers is substantially larger, leading to a less stringent requirement on the thicknesses of the regions 2, 3.

Subject to the above requirement on the thickness, the carriers will then diffuse through the regions 2, 3 sufficiently fast so that they will retain most of their energy gained during the absorption process in the junction 1, 7. The carrier energy - composed of the thermal energy and electrostatic energy due to doping - then remains constant and, as the carriers are cooled, their thermal energy is converted into electrostatic energy, eventually resulting in a higher voltage.

It is possible, on account of very different effective masses of electrons and holes in some semiconductors, that most of the thermal energy gained in the absorption event will be transferred predominantly to one type of carrier, usually electrons. The carrier temperatures on the two sides of the junction 1, 7 will then also be different, and the formalism outlined above should be augmented accordingly. The device design simplifies if only one type of carrier (electrons, say) contains a substantial amount of the absorbed heat when the other side of the junction 1, 7 (in this example, the p-side) can be doped uniformly. This would be the case for the second p-type semiconductor doped material 2 in Fig. 2, referred to as a window layer.

Example 4

A specific embodiment of a hot carrier solar cell according to this invention is shown in Fig. 3 (having identical parts as the solar cell in Fig. 2). The donor and acceptor densities $N_D(x_n)$, $N_A(x_p)$ as a function of distance x are shown in Fig. 4.

The first n-type semiconductor doped region 3 is a GaAs n-type layer having a doping density $N_D(0) = 5 \times 10^{18}$ cm$^{-3}$ at the junction end, a thickness $d_n = 0.1$ $\mu$m and a non-uniform doping profile given by the equation

$$N_D(x_n) = N_D(0)\left\{1 - \frac{x_n}{d_n}\left(1 - \frac{T_o}{T_h}\right)\right\}^{\frac{3}{2}},$$

containing 5 periods of 200 Å GaAs quantum wells with 80 Å Al$_{0.52}$Ga$_{0.48}$As barriers.

The second p-type semiconductor doped region 2 is a Al$_{0.85}$Ga$_{0.15}$As p-type layer, having a uniform doping density $N_A(0) = N_A(x_p) = 5 \times 10^{18}$ cm$^{-3}$ at the junction and contact ends, a thickness $d_p = 30$ nm, thus being a window layer.

The semiconductor junction 7 is GaAs n-type layer, having an n-type uniform doping density of $1 \times 10^{14}$ cm$^{-3}$, a thickness of 1.5 $\mu$m, containing 80 periods of 200 Å GaAs quantum wells with 80 Å Al$_{0.52}$Ga$_{0.48}$As barriers.

A general growth of the layers can be carried out according to prior art [US Patent. 9,842,957 B1 and X. Wang et al., Design of GaAs Solar Cells Operating Close to the Shockley-Queisser Limit, IEEE J. Photovoltaics 3, 737, 2013.] The quantum well structures can be prepared according to prior art [Y. Rosenwaks et al, Hot-carrier cooling in GaAs: Quantum wells versus bulk, Phys. Rev. B 48, 14675, 1993]. As holes in GaAs are substantially heavier than electrons, electrons will contain significantly more thermal energy than holes after separation in the junction 7. This embodiment therefore includes only one adiabatic cooling region for electrons. In principle and with other materials, the doping profiles of the regions 2, 3 in terms of their (non-)uniformity can be swapped or both can be non-uniform.

Example 5

The band diagrams of a single heterojunction of a solar cell are shown schematically in Fig. 5 (at equilibrium) and Fig. 6 (in operation under illumination). A single heterojunction is characterised by a different band gap (i. e. the energy range between the top of the valence band 16 and the bottom of the conduction band 15) of one of the regions 2 or 3 in comparison to the band gaps of the junction 7 and the other region 3 or 2.

The band diagrams of a double heterojunction of a solar cell are shown schematically in Fig. 7 (at equilibrium) and Fig. 8 (in operation under illumination). A double heterojunction is characterised by a different band gap (i. e. the energy range between the top of the valence band 16 and the bottom of the conduction band 15) of each of the regions 2 and 3 in comparison to the band gap of the junction 7.

At equilibrium (no illumination, heating or applied voltage), the Fermi levels 14 of the electrons in both regions 2, 3 as well as in the junction 7 have equal energy. Under illumination, these Fermi levels 14 have different energies and a potential energy barrier qV is created across the junction 7. Illumination generates electron-hole pairs (arrow 11) in the junction 7 such that electrons appear in the conduction band 15 (at its lowest energy level or higher) and holes appear in the valence band 16 (at its highest energy level or lower). This extra energy characterizes the charge carriers as hot carriers in thermodynamic terms. Because of a strong electric field of at least 1 kV/cm applied in the junction, the electrons in the conduction band 15 are separated towards the n-side of the junction 7 (top arrow 12) and further into the first n-type semiconductor doped region 2 (top arrow 13) and the holes in the valence band 16 are separated towards the p-side of the junction 7 (bottom arrow 12) and further into the second p-type semiconductor doped region 3 (bottom arrow 13). As the charge carriers diffuse across the regions 2, 3 (arrows 13) towards the contacts 4, 5, they are adiabatically cooled owing to the non-uniform doping profiles of the regions 2, 3. In this way, the carrier entropy remains constant and equals the thermoelectric power, which results in the thermal energy of the carriers being gradually converted into electrostatic energy towards the contacts.

**Industrial Applicability**

The above-described charge carrier separation device can increase the efficiency of solar cells and thermoelectric elements.

**Reference Signs List**

1    junction of a thermoelectric element

2    first n-type semiconductor doped region

3    second p-type semiconductor doped region

4    positive electric contact

5    negative electric contact

6    heat sink

7    junction of a solar cell

8    illumination beam

11    electron-hole generation

12    separation of the hot charge carriers by the electric field of the junction

13    adiabatic cooling of the charge carriers

14    Fermi level or chemical potential of the charge carriers

15    conduction band

16    valence band

**Claims**

1.  A charge carrier separation device for adiabatic cooling of hot charge carriers, the device comprising a first n-type semiconductor doped region (2) and a second p-type semiconductor doped region (3), wherein the regions (2, 3) are separated by a junction (1, 7) susceptible upon heating or illumination to creation of positively charged and negatively charged mobile charge carriers, wherein the first n-type semiconductor doped region (2) is further connected to a negative electric contact (5) for collecting the negatively charged mobile charge carriers and the second p-type semiconductor doped region (3) is further connected to a positive electric contact (4) for collecting the positively charged mobile charge carriers, each region (2, 3) thus having a junction end and a contact end and the junction (1, 7) thus having an n-side and a p-side,

    **characterised in that** the first n-type semiconductor doped region (2) comprises a non-uniform doping profile in which the donor dopant density $N_D(x_n)$ at a distance $x_n$ measured from the junction end of the first n-type semiconductor doped region (2) towards the negative electric contact (5) varies according to the equation

    $$N_D(x_n) = N_D(0) \left\{ \frac{T_n(x_n)}{T_h} \right\}^{\frac{3}{2}},$$

    where $N_D(0)$ is a donor doping density at the junction end of the first n-type semiconductor doped region (2) where $x_n = 0$; $T_n(x_n)$ is a charge carrier temperature at a distance $x_n$ measured from the junction end of the first n-type semiconductor doped region (2) towards the negative electric contact (5); and $T_h$ is a charge carrier temperature at the junction end of the first n-type semiconductor doped region (2) where $x_n = 0$, $T_h$ being higher than $T_n$, and/or **in that** the second p-type semiconductor doped region (3) comprises a non-uniform doping profile in which the acceptor dopant density $N_A(x_p)$ at a distance $x_p$ measured from the junction end of the second p-type semiconductor doped region (3) towards the positive electric contact (4) varies according to the equation

    $$N_A(x_p) = N_A(0) \left\{ \frac{T_p(x_p)}{T_h} \right\}^{\frac{3}{2}},$$

    where $N_A(0)$ is an acceptor doping density at the junction end of the second p-type semiconductor doped region (3) where $x_p = 0$; $T_p(x_p)$ is a charge carrier temperature at a distance $x_p$ measured from the junction end of the second p-type semiconductor doped region (3) towards the positive electric contact (4); and $T_h$ is a charge carrier temperature at the junction end of the second p-type semiconductor doped region (3) where $x_p = 0$, $T_h$ being higher than $T_p$.

2.  A charge carrier separation device for adiabatic cooling of hot charge carriers, the device comprising a first n-type semiconductor doped region (2) and a second p-type semiconductor doped region (3), wherein the regions (2, 3) are separated by a junction (1, 7) susceptible upon heating or illumination to creation of positively charged and negatively charged mobile charge carriers, wherein the first n-type semiconductor doped region (2) is further connected to a negative electric contact (5) for collecting the negatively charged mobile charge carriers and the second p-type semiconductor doped region (3) is further connected to a positive electric contact (4) for collecting the positively charged mobile charge carriers, each region (2, 3) thus having a junction end and a contact end and the junction (1, 7) thus having an n-side and a p-side,

    **characterised in that** the first n-type semiconductor doped region (2) comprises a non-uniform doping profile in which the donor dopant density $N_D(x_n)$ at a distance $x_n$ measured from the junction end of the first n-type semiconductor doped region (2) towards the negative electric contact (5) varies according to the equation

$$N_D(x_n) = N_D(0)\left\{1 - \frac{x_n}{d_n}\left(1 - \frac{T_o}{T_h}\right)\right\}^{\frac{3}{2}},$$

where $N_D(0)$ is a donor doping density at the junction end of the first n-type semiconductor doped region (2) where $x_n = 0$; $d_n$ is a distance measured between the junction end of the first n-type semiconductor doped region (2) and the negative electric contact (5) where $x_n = $ max; $T_o$ is a charge carrier temperature measured at the contact end of the first n-type semiconductor doped region (2) where $x_n = d_n$; and $T_h$ is a charge carrier temperature at the junction end of the first n-type semiconductor doped region (2) where $x_n = 0$, $T_h$ being higher than $T_o$, and/or **in that** the second p-type semiconductor doped region (3) comprises a non-uniform doping profile in which the acceptor dopant density $N_A(x_p)$ at a distance $x_p$ measured from the junction end of the second p-type semiconductor doped region (3) towards the positive electric contact (4) varies according to the equation

$$N_A(x_n) = N_A(0)\left\{1 - \frac{x_p}{d_p}\left(1 - \frac{T_o}{T_h}\right)\right\}^{\frac{3}{2}},$$

where $N_A(0)$ is an acceptor doping density at the junction end of the second p-type semiconductor doped region (3) where $x_p = 0$; $d_p$ is a distance measured between the junction end of the second p-type semiconductor doped region (3) and the positive electric contact (4) where $x_p = $ max; $T_o$ is a charge carrier temperature measured at the contact end of the second p-type semiconductor doped region (3) where $x_p = d_p$; and $T_h$ is a charge carrier temperature at the junction end of the second p-type semiconductor doped region (3) where $x_p = 0$, $T_h$ being higher than $T_o$.

3. The device according to claim 1 or 2, the device being a thermoelectric element, wherein the junction (1) is a metal junction, wherein the positive and negative electric contacts (4, 5) are further connected to a heat sink (6).

4. The device according to claim 1 or 2, the device being a solar cell, wherein the junction (7) is a semiconductor junction.

5. The device according to claim 4, wherein the junction (1, 7) is intrinsic or doped to an n- or p-conductivity type.

6. The device according to claim 4 or 5, wherein the junction (1, 7) is a single heterojunction, or a double heterojunction.

7. The device according to claim 6, wherein the single heterojunction comprises GaAs.

8. The device according to claim 7, wherein the GaAs heterojunction is doped to an n-conductivity type, wherein the GaAs heterojunction is coupled at its p-side with the second p-type semiconductor doped region (3) comprising a $Ga_xAl_{1-x}As$ window layer having p-conductivity type, and wherein the GaAs heterojunction is coupled at its n-side with the first n-type semiconductor doped region (2) comprising a GaAs layer having n-conductivity type.

9. The device according to claim 7 or 8, wherein the donor dopants are selected from silicon, tin, selenium, tellurium and sulfur, and wherein the acceptor dopants are selected from zinc, beryllium, cadmium, magnesium and carbon.

10. The device according to claim 6, wherein the double heterojunction comprises a semiconductor having a perovskite structure, preferably $CH_3NH_3PbI_3$, sandwiched between a doped electron transporting layer, preferably $TiO_2$ doped with nitrogen, and a doped hole transporting layer, preferably CuI doped with sulfur.

11. The device according to any of the previous claims, wherein the donor doping density $N_D(0)$ and the acceptor doping density $N_A(0)$ range from $10^{18}$ to $10^{20}$ cm$^{-3}$.

12. The device according to any of the previous claims, wherein the thickness of the junction (1, 7) ranges from 100 nm to 10 $\mu$m.

13. A method for separating mobile charge carriers in the solar cell according to claims 4 to 12, comprising the steps of:

a. illuminating the junction (7) by light, thereby creating positively charged and negatively charged mobile charge carriers;
b. allowing to separate said negatively charged mobile charge carriers to the n-side of the junction (7) and said positively charged mobile charge carriers to the p-side of the junction (7) by means of an electric field of at least 1 kV/cm, wherein said mobile charge carriers have a charge carrier temperature $T_h$ at the respective side of the junction (7);

c. transporting said negatively charged mobile charge carriers from the junction end towards to the contact end of the first n-type semiconductor doped region (2) and said positively charged mobile charge carriers from the junction end towards to the contact end of the second p-type semiconductor doped region (3), thus adiabatically cooling said mobile charge carriers; and

d. collecting said negatively charged mobile charge carriers at the contact end of the first n-type semiconductor doped region (2) and said positively charged mobile charge carriers at the contact end of the second p-type semiconductor doped region (3).

14. A method for separating mobile charge carriers in the thermoelectric element according to claim 3 or claims 11 to 12 when dependent on claim 3, comprising the steps of:

a. heating the junction (1), thereby creating positively charged and negatively charged mobile charge carriers having a charge carrier temperature $T_h$;

b. allowing to separate said negatively charged mobile charge carriers to the n-side of the junction (1) and said positively charged mobile charge carriers to the p-side of the junction (1) by means of an electric field of at least 1 kV/cm, wherein said mobile charge carriers have a charge carrier temperature $T_h$ at the respective side of the junction (1);

c. transporting said negatively charged mobile charge carriers from the junction end towards to the contact end of the first n-type semiconductor doped region (2) and said positively charged mobile charge carriers from the junction end towards to the contact end of the second p-type semiconductor doped region (3), thus adiabatically cooling said mobile charge carriers; and

d. collecting said negatively charged mobile charge carriers at the contact end of the first n-type semiconductor doped region (2) and said positively charged mobile charge carriers at the contact end of the second p-type semiconductor doped region (3).

**Patentansprüche**

1. Eine Ladungsträger-Trennvorrichtung zur adiabatischen Kühlung von heißen Ladungsträgern, wobei die Vorrichtung einen ersten n-Typ-Halbleiter-dotierten Bereich (2) und einen zweiten p-Typ-Halbleiter-dotierten Bereich (3) umfasst, wobei die Bereiche (2, 3) durch einen Übergang (1, 7) getrennt sind, der bei Erwärmung oder Beleuchtung anfällig ist, um positiv geladene und negativ geladene mobile Ladungsträger zu erzeugen, wobei der erste n-Typ-Halbleiter-dotierte Bereich (2) ferner mit einem negativen elektrischen Kontakt (5) zum Sammeln der negativ geladenen mobilen Ladungsträger verbunden ist und der zweite p-Typ-Halbleiter-dotierte Bereich (3) ferner mit einem positiven elektrischen Kontakt (4) zum Sammeln der positiv geladenen mobilen Ladungsträger verbunden ist, wobei jeder Bereich (2, 3) somit ein Übergangsende und ein Kontaktende aufweist und der Übergang (1, 7) somit eine n-Seite und eine p-Seite aufweist,

**dadurch gekennzeichnet, dass** der erste n-Typ-Halbleiter-dotierte Bereich (2) ein ungleichmäßiges Dotierungsprofil umfasst, in dem die Donor-Dotierstoffdichte $N_D(x_n)$ in einem Abstand $x_n$, der vom Übergangsende des ersten n-Typ-Halbleiter-dotierten Bereichs (2) in Richtung des negativen elektrischen Kontakts (5) gemessen wird, gemäß der Gleichung variiert

$$N_D(x_n) = N_D(0)\left\{\frac{T_n(x_n)}{T_h}\right\}^{\frac{3}{2}},$$

wobei $N_D(0)$ eine Donor-Dotierungsdichte am Übergangsende des ersten n-Typ-Halbleiter-dotierten Bereichs (2) ist, wobei $x_n = 0$; $T_n(x_n)$ eine Ladungsträgertemperatur in einem Abstand $x_n$ ist, der vom Übergangsende des ersten n-Typ-Halbleiter-dotierten Bereichs (2) in Richtung des negativen elektrischen Kontakts (5) gemessen wird; und $T_h$ eine Ladungsträgertemperatur am Übergangsende des ersten n-Typ-Halbleiter-dotierten Bereichs (2) ist, wobei $x_n = 0$, wobei $T_h$ höher als $T_n$ ist, und/oder **dass** der zweite p-Typ-Halbleiter-dotierte Bereich (3) ein ungleichmäßiges Dotierungsprofil umfasst, in dem die Akzeptor-Dotierstoffdichte $N_A(x_p)$ in einem Abstand $x_p$, der vom Übergangsende des zweiten p-Typ-Halbleiter-dotierten Bereichs (3) in Richtung des positiven elektrischen Kontakts (4) gemessen wird, gemäß der Gleichung variiert

$$N_A\left(x_p\right) = \mathrm{N}_A(0)\left\{\frac{\mathrm{T}_p(\mathrm{x}_p)}{T_h}\right\}^{\frac{3}{2}},$$

wobei $N_A(0)$ eine Akzeptor-Dotierungsdichte am Übergangsende des zweiten p-Typ-Halbleiter-dotierten Bereichs (3) ist, wobei $x_p = 0$; $T_p(x_p)$ eine Ladungsträgertemperatur in einem Abstand $x_p$ ist, der vom Übergangsende des zweiten p-Typ-Halbleiter-dotierten Bereichs (3) in Richtung des positiven elektrischen Kontakts (4) gemessen wird; und $T_h$ eine Ladungsträgertemperatur am Übergangsende des zweiten p-Typ-Halbleiter-dotierten Bereichs (3) ist, wobei $x_p = 0$, wobei $T_h$ höher als $T_p$ ist.

2. Eine Ladungsträger-Trennvorrichtung zur adiabatischen Kühlung von heißen Ladungsträgern, wobei die Vorrichtung einen ersten n-Typ-Halbleiter-dotierten Bereich (2) und einen zweiten p-Typ-Halbleiter-dotierten Bereich (3) umfasst, wobei die Bereiche (2, 3) durch einen Übergang (1, 7) getrennt sind, der bei Erwärmung oder Beleuchtung anfällig ist, um positiv geladene und negativ geladene mobile Ladungsträger zu erzeugen, wobei der erste n-Typ-Halbleiter-dotierte Bereich (2) ferner mit einem negativen elektrischen Kontakt (5) zum Sammeln der negativ geladenen mobilen Ladungsträger verbunden ist und der zweite p-Typ-Halbleiter-dotierte Bereich (3) ferner mit einem positiven elektrischen Kontakt (4) zum Sammeln der positiv geladenen mobilen Ladungsträger verbunden ist, wobei jeder Bereich (2, 3) somit ein Übergangsende und ein Kontaktende aufweist und der Übergang (1, 7) somit eine n-Seite und eine p-Seite aufweist,

**dadurch gekennzeichnet, dass** der erste n-Typ-Halbleiter-dotierte Bereich (2) ein ungleichmäßiges Dotierungsprofil umfasst, in dem die Donor-Dotierstoffdichte $N_D(x_n)$ in einem Abstand $x_n$, der vom Übergangsende des ersten n-Typ-Halbleiter-dotierten Bereichs (2) in Richtung des negativen elektrischen Kontakts (5) gemessen wird, gemäß der Gleichung variiert

$$N_D(x_n) = N_D(0)\left\{1 - \frac{x_n}{d_n}\left(1 - \frac{T_o}{T_h}\right)\right\}^{\frac{3}{2}},$$

wobei $N_D(0)$ eine Donor-Dotierungsdichte am Übergangsende des ersten n-Typ-Halbleiter-dotierten Bereichs (2) ist, wobei $x_n = 0$ ist; $d_n$ eine Distanz ist, die zwischen dem Übergangsende des ersten n-Typ-Halbleiter-dotierten Bereichs (2) und dem negativen elektrischen Kontakt (5) gemessen wird, wobei $x_n = \max$ ist; $T_o$ eine Ladungsträgertemperatur ist, die am Kontaktende des ersten n-Typ-Halbleiter-dotierten Bereichs (2) gemessen wird, wobei $x_n = d_n$ ist; und $T_h$ eine Ladungsträgertemperatur am Übergangsende des ersten n-Typ-Halbleiter-dotierten Bereichs (2) ist, wobei $x_n = 0$, wobei $T_h$ höher als $T_o$ ist,

und/oder **dass** der zweite p-Typ-Halbleiter-dotierte Bereich (3) ein ungleichmäßiges Dotierungsprofil umfasst, in dem die Akzeptor-Dotierstoffdichte $N_A(x_p)$ in einem Abstand $x_p$, der vom Übergangsende des zweiten p-Typ-Halbleiter-dotierten Bereichs (3) in Richtung des positiven elektrischen Kontakts (4) gemessen wird, gemäß der Gleichung variiert

$$N_A(x_n) = N_A(0)\left\{1 - \frac{x_p}{d_p}\left(1 - \frac{T_o}{T_h}\right)\right\}^{\frac{3}{2}},$$

wobei $N_A(0)$ eine Akzeptor-Dotierungsdichte am Übergangsende des zweiten p-Typ-Halbleiter-dotierten Bereichs (3) ist, wobei $x_p = 0$; $d_p$ ein Abstand ist, der zwischen dem Übergangsende des zweiten p-Typ-Halbleiter-dotierten Bereichs (3) und dem positiven elektrischen Kontakt (4) gemessen wird, wobei $x_p = \max$ ist; $T_o$ eine Ladungsträgertemperatur ist, die am Kontaktende des zweiten p-Typ-Halbleiter-dotierten Bereichs (3) gemessen wird, wobei $x_p = d_p$ ist; und $T_h$ eine Ladungsträgertemperatur am Übergangsende des zweiten p-Typ-Halbleiter-dotierten Bereichs (3) ist, wobei $x_p = 0$, wobei $T_h$ höher als $T_o$ ist.

3. Die Vorrichtung nach Anspruch 1 oder 2, wobei die Vorrichtung ein thermoelektrisches Element ist, wobei der Übergang (1) ein Metallübergang ist, wobei die positiven und negativen elektrischen Kontakte (4, 5) ferner mit einer Wärmesenke (6) verbunden sind.

4. Die Vorrichtung nach Anspruch 1 oder 2, wobei die Vorrichtung eine Solarzelle ist, wobei der Übergang (7) eine Halbleiterübergang ist.

5. Die Vorrichtung nach Anspruch 4, wobei der Übergang (1, 7) intrinsisch oder zu einem n- oder p-Leitfähigkeitstyp dotiert ist.

6. Die Vorrichtung nach Anspruch 4 oder 5, wobei der Übergang (1, 7) ein einzelner Heteroübergang oder ein Doppelheteroübergang ist.

7. Die Vorrichtung nach Anspruch 6, wobei der einzelne Heteroübergang GaAs umfasst.

8. Die Vorrichtung nach Anspruch 7, wobei der GaAs-Heteroübergang mit einem n-Leitfähigkeitstyp dotiert ist, wobei der GaAs-Heteroübergang an seiner p-Seite mit dem zweiten p-Typ-Halbleiter-dotierten Bereich (3) gekoppelt ist, der eine $Ga_xAl_{1-x}As$-Fensterschicht mit p-Leitfähigkeitstyp umfasst, und wobei der GaAs-Heteroübergang an seiner n-Seite mit dem ersten n-Typ-Halbleiter-dotierten Bereich (2) gekoppelt ist, der eine GaAs-Schicht mit einem n-Leitfähigkeitstyp umfasst.

9. Die Vorrichtung nach Anspruch 7 oder 8, wobei die Donor-Dotierstoffe ausgewählt aus Silizium, Zinn, Selen, Tellur und Schwefel sind, und wobei die Akzeptor-Dotierstoffe ausgewählt aus Zink, Beryllium, Cadmium, Magnesium und Kohlenstoff sind.

10. Die Vorrichtung nach Anspruch 6, wobei der Doppel-Heteroübergang einen Halbleiter mit einer Perowskit-Struktur, vorzugsweise $CH_3NH_3PbI_3$, umfasst, der sandwichartig zwischen einer dotierten Elektronentransportschicht, vorzugsweise $TiO_2$, dotiert mit Stickstoff, und einer dotierten Lochtransportschicht, vorzugsweise CuI, dotiert mit Schwefel, angeordnet ist.

11. Die Vorrichtung nach einem der vorhergehenden Ansprüche, wobei die Donor-Dotierungsdichte $N_D(0)$ und die Akzeptor-Dotierungsdichte $N_A(0)$ im Bereich von $10^{18}$ bis $10^{20}$ $cm^{-3}$ liegen.

12. Die Vorrichtung nach einem der vorhergehenden Ansprüche, wobei die Dicke des Übergangs (1, 7) im Bereich von 100 nm bis 10 $\mu$m liegt.

13. Ein Verfahren zum Trennen von mobilen Ladungsträgern in der Solarzelle nach den Ansprüchen 4 bis 12, umfassend die folgenden Schritte:

    a. Beleuchten des Übergangs (7) durch Licht, wodurch positiv geladene und negativ geladene mobile Ladungsträger erzeugt werden;
    b. Trennen lassen der negativ geladenen mobilen Ladungsträger an die n-Seite des Übergangs (7) und der positiv geladenen mobilen Ladungsträger an die p-Seite des Übergangs (7) mittels eines elektrischen Feldes von mindestens 1 kV/cm, wobei die mobilen Ladungsträger eine Ladungsträgertemperatur $T_h$ an der jeweiligen Seite des Übergangs (7) haben;
    c. Transportieren der negativ geladenen mobilen Ladungsträger vom Übergangsende in Richtung des Kontaktendes des ersten n-Typ-Halbleiter-dotierten Bereichs (2) und der positiv geladenen mobilen Ladungsträger vom Übergangsende in Richtung des Kontaktendes des zweiten p-Typ-Halbleiter-dotierten Bereichs (3), wodurch die mobilen Ladungsträger adiabatisch gekühlt werden; und
    d. Sammeln der negativ geladenen mobilen Ladungsträger am Kontaktende des ersten n-Typ-Halbleiter-dotierten Bereichs (2) und der positiv geladenen mobilen Ladungsträger am Kontaktende des zweiten p-Typ-Halbleiter-dotierten Bereichs (3).

14. Ein Verfahren zum Trennen von mobilen Ladungsträgern im thermoelektrischen Element nach Anspruch 3 oder den Ansprüchen 11 bis 12, wenn abhängig von Anspruch 3, umfassend die folgenden Schritte:

    a. Erwärmen des Übergangs (1), wodurch positiv geladene und negativ geladene mobile Ladungsträger mit einer Ladungsträgertemperatur $T_h$ erzeugt werden;
    b. Trennen lassen der negativ geladenen mobilen Ladungsträger an die n-Seite des Übergangs (1) und der positiv geladenen mobilen Ladungsträger an die p-Seite des Übergangs (1) mittels eines elektrischen Feldes von mindestens 1 kV/cm, wobei die mobilen Ladungsträger eine Ladungsträgertemperatur $T_h$ an der jeweiligen Seite des Übergangs (1) haben;
    c. Transportieren der negativ geladenen mobilen Ladungsträger vom Übergangsende in Richtung des Kontaktendes des ersten n-Typ-Halbleiter-dotierten Bereichs (2) und der positiv geladenen mobilen Ladungsträger vom Übergangsende in Richtung des Kontaktendes des zweiten p-Typ-Halbleiter-dotierten Bereichs (3), wodurch die mobilen Ladungsträger adiabatisch gekühlt werden; und

d. Sammeln der negativ geladenen mobilen Ladungsträger am Kontaktende des ersten n-Typ-Halbleiter-dotierten Bereichs (2) und der positiv geladenen mobilen Ladungsträger am Kontaktende des zweiten p-Typ-Halbleiter-dotierten Bereichs (3).

**Revendications**

1. Un dispositif de séparation de porteurs de charge pour le refroidissement adiabatique de porteurs de charge chauds, où le dispositif comprend une première région dopée de semi-conducteur de type n (2) et une seconde région dopée de semi-conducteur de type p (3), où les régions (2, 3) sont séparées par une jonction (1, 7) susceptible lors du chauffage ou de l'éclairage pour la création de porteurs de charge mobiles chargés positivement et chargés négativement, où la première région dopée de semi-conducteur de type n (2) est en outre connectée à un contact électrique négatif (5) pour collecter les porteurs de charge mobiles chargés négativement et la seconde région dopée de semi-conducteur de type p (3) est en outre connectée à un contact électrique positif (4) pour collecter les porteurs de charge mobiles chargés positivement, où chaque région (2, 3) a ainsi une extrémité de jonction et une extrémité de contact et la jonction (1, 7) a ainsi un côté n et un côté p,

   **caractérisé en ce que** la première région dopée de semi-conducteur de type n (2) comprend un profil de dopage non uniforme, dans lequel la densité de dopant donneur $N_D(x_n)$ à une distance $x_n$ mesurée à partir de l'extrémité de jonction de la première région dopée de semi-conducteur de type n (2) vers le contact électrique négatif (5) varie selon l'équation

$$N_D(x_n) = N_D(0) \left\{ \frac{T_n(x_n)}{T_h} \right\}^{\frac{3}{2}},$$

   où $N_D(0)$ est une densité de dopage de donneur au niveau de l'extrémité de jonction de la première région dopée de semi-conducteur de type n (2), où $x_n = 0$; $T_n(x_n)$ est une température de porteurs de charge à une distance $x_n$ mesurée à partir de l'extrémité de jonction de la première région dopée de semi-conducteur de type n (2) vers le contact électrique négatif (5); et $T_h$ est une température de porteurs de charge à l'extrémité de jonction de la première région dopée de semi-conducteur de type n (2), où $x_n = 0$, où $T_h$ est supérieur à $T_n$,

   et/ou **en ce que** la seconde région dopée de semi-conducteur de type p (3) comprend un profil de dopage non uniforme, dans lequel la densité de dopant accepteur $N_A(x_p)$ à une distance $x_p$ mesurée à partir de l'extrémité de jonction de la seconde région dopée de semi-conducteur de type p (3) vers le contact électrique positif (4) varie selon l'équation

$$N_A(x_p) = N_A(0) \left\{ \frac{T_p(x_p)}{T_h} \right\}^{\frac{3}{2}},$$

   où $N_A(0)$ est une densité de dopage d'accepteur à l'extrémité de jonction de la deuxième région dopée de semi-conducteur de type p (3) où $x_p = 0$; $T_p(x_p)$ est une température de porteurs de charge à une distance $x_p$ mesurée à partir de l'extrémité de jonction de la deuxième région dopée de semi-conducteur de type p (3) vers le contact électrique positif (4); et $T_h$ est une température de porteurs de charge à l'extrémité de jonction de la deuxième région dopée de semi-conducteur de type p (3), où $x_p = 0$, où $T_h$ est supérieur à $T_p$.

2. Un dispositif de séparation de porteurs de charge pour le refroidissement adiabatique de porteurs de charge chauds, où le dispositif comprend une première région dopée de semi-conducteur de type n (2) et une seconde région dopée de semi-conducteur de type p (3), où les régions (2, 3) sont séparées par une jonction (1, 7) susceptible lors du chauffage ou de l'éclairage pour la création de porteurs de charge mobiles chargés positivement et chargés négativement, où la première région dopée de semi-conducteur de type n (2) est en outre connectée à un contact électrique négatif (5) pour collecter les porteurs de charge mobiles chargés négativement et la seconde région dopée de semi-conducteur de type p (3) est en outre connectée à un contact électrique positif (4) pour collecter les porteurs de charge mobiles chargés positivement, où chaque région (2, 3) a ainsi une extrémité de jonction et une extrémité de contact et la jonction (1, 7) a ainsi un côté n et un côté p,

**caractérisé en ce que** la première région dopée de semi-conducteur de type n (2) comprend un profil de dopage non uniforme, dans lequel la densité de dopant donneur $N_D(x_n)$ à une distance $x_n$ mesurée à partir de l'extrémité de jonction de la première région dopée de semi-conducteur de type n (2) vers le contact électrique négatif (5) varie selon l'équation

$$N_D(x_n) = N_D(0)\left\{1 - \frac{x_n}{d_n}\left(1 - \frac{T_o}{T_h}\right)\right\}^{\frac{3}{2}},$$

où $N_D(0)$ est une densité de dopage de donneur au niveau de l'extrémité de jonction de la première région dopée de semi-conducteur de type n (2), où $x_n = 0$; $d_n$ est une distance mesurée entre l'extrémité de jonction de la première région dopée de semi-conducteur de type n (2) et le contact électrique négatif (5), où $x_n$ = max; $T_o$ est une température de porteurs de charge mesurée au niveau de l'extrémité de contact de la première région dopée de semi-conducteur de type n (2), où $x_n = d_n$; et $T_h$ est une température de porteurs de charge à l'extrémité de jonction de la première région dopée de semi-conducteur de type n (2), où $x_n = 0$, où $T_h$ est supérieur à $T_o$, et/ou **en ce que** la seconde région dopée de semi-conducteur de type p (3) comprend un profil de dopage non uniforme, dans lequel la densité de dopant accepteur $N_A(x_p)$ à une distance $x_p$ mesurée à partir de l'extrémité de jonction de la seconde région dopée de semi-conducteur de type p (3) vers le contact électrique positif (4) varie selon l'équation

$$N_A(x_n) = N_A(0)\left\{1 - \frac{x_p}{d_p}\left(1 - \frac{T_o}{T_h}\right)\right\}^{\frac{3}{2}},$$

où $N_A(0)$ est une densité de dopage d'accepteur à l'extrémité de jonction de la deuxième région dopée de semi-conducteur de type p (3) où $x_p = 0$; $d_p$ est une distance mesurée entre l'extrémité de jonction de la seconde région dopée de semi-conducteur de type p (3) et le contact électrique positif (4), où $x_p$ = max; $T_o$ est une température de porteurs de charge mesurée au niveau de l'extrémité de contact de la seconde région dopée de semi-conducteur de type p (3), où $x_p = d_p$; $T_h$ est une température de porteurs de charge à l'extrémité de jonction de la deuxième région dopée de semi-conducteur de type p (3), où $x_p = 0$, où $T_h$ est supérieur à $T_o$.

3. Le dispositif selon la revendication 1 ou 2, où le dispositif est un élément thermoélectrique, où la jonction (1) est une jonction métallique, où les contacts électriques positif et négatif (4, 5) sont en outre connectés à un dissipateur thermique (6).

4. Le dispositif selon la revendication 1 ou 2, où le dispositif est une cellule solaire, où la jonction (7) est une jonction semi-conductrice.

5. Le dispositif selon la revendication 4, où la jonction (1, 7) est intrinsèque ou dopée à un type de conductivité n ou p.

6. Le dispositif selon la revendication 4 ou 5, où la jonction (1, 7) est une hétérojonction unique, ou une hétérojonction double.

7. Le dispositif selon la revendication 6, où l'hétérojonction unique comprend du GaAs.

8. Le dispositif selon la revendication 7, où l'hétérojonction GaAs est dopée à un type de conductivité n, où l'hétérojonction GaAs est couplée sur son côté p avec la deuxième région dopée semi-conductrice de type p (3) comprenant une couche de fenêtre $Ga_xAl_{1-x}As$ ayant un type de conductivité p, et où l'hétérojonction GaAs est couplée sur son côté n avec la première région dopée semi-conductrice de type n (2) comprenant une couche de GaAs ayant un type de conductivité n.

9. Le dispositif selon la revendication 7 ou 8, où les dopants donneurs sont choisis parmi le silicium, l'étain, le sélénium, le tellure et le soufre, et où les dopants accepteurs sont choisis parmi le zinc, le béryllium, le cadmium, le magnésium et le carbone.

10. Le dispositif selon la revendication 6, où l'hétérojonction double comprend un semi-conducteur ayant une structure pérovskite, de préférence $CH_3NH_3PbI_3$, prise en sandwich entre une couche de transport d'électrons dopée, de préférence $TiO_2$ dopée avec de l'azote, et une couche de transport de trous dopée, de préférence CuI dopée avec du

soufre.

11. Le dispositif selon l'une quelconque des revendications précédentes, où la densité de dopage de donneur $N_D(0)$ et la densité de dopage d'accepteur $N_A(0)$ vont de $10^{18}$ à $10^{20}$ cm$^{-3}$.

12. Le dispositif selon l'une quelconque des revendications précédentes, où l'épaisseur de la jonction (1, 7) est comprise entre 100 nm et 10 μm.

13. Un procédé de séparation de porteurs de charge mobiles dans la cellule solaire selon les revendications 4 à 12, comprenant les étapes consistant à :

   a. éclairer la jonction (7) par la lumière, créant ainsi des porteurs de charges mobiles chargés positivement et chargés négativement ;
   b. permettre de séparer lesdits porteurs de charge mobile chargés négativement vers le côté n de la jonction (7) et lesdits porteurs de charge mobile chargés positivement vers le côté p de la jonction (7) au moyen d'un champ électrique d'au moins 1 kV/cm, où lesdits porteurs de charge mobiles ont une température de porteurs de charge $T_h$ sur le côté respectif de la jonction (7) ;
   c. transporter lesdits porteurs de charge mobiles chargés négativement de l'extrémité de jonction vers l'extrémité de contact de la première région dopée de semi-conducteur de type n (2) et lesdits porteurs de charge mobiles chargés positivement de l'extrémité de jonction vers l'extrémité de contact de la seconde région dopée de semi-conducteur de type p (3), refroidissant ainsi de manière adiabatique lesdits porteurs de charge mobile ; et
   d. collecter lesdits porteurs de charge mobile chargés négativement au niveau de l'extrémité de contact de la première région dopée de semi-conducteur de type n (2) et lesdits porteurs de charge mobile chargés positivement au niveau de l'extrémité de contact de la seconde région dopée de semi-conducteur de type p (3).

14. Un procédé de séparation de porteurs de charge mobiles dans l'élément thermoélectrique selon la revendication 3 ou les revendications 11 à 12 lorsqu'elles dépendent de la revendication 3, comprenant les étapes consistant à :

   a. chauffer la jonction (1), créant ainsi des porteurs de charge mobiles chargés positivement et chargés négativement ayant une température de porteurs de charge $T_h$ ;
   b. permettre de séparer lesdits porteurs de charge mobile chargés négativement vers le côté n de la jonction (1) et lesdits porteurs de charge mobile chargés positivement vers le côté p de la jonction (1) au moyen d'un champ électrique d'au moins 1 kV/cm, où lesdits porteurs de charge mobiles ont une température de porteurs de charge $T_h$ sur le côté respectif de la jonction (1) ;
   c. transporter lesdits porteurs de charge mobiles chargés négativement de l'extrémité de jonction vers l'extrémité de contact de la première région dopée de semi-conducteur de type n (2) et lesdits porteurs de charge mobiles chargés positivement de l'extrémité de jonction vers l'extrémité de contact de la seconde région dopée de semi-conducteur de type p (3), refroidissant ainsi de manière adiabatique lesdits porteurs de charge mobile ; et
   d. collecter lesdits porteurs de charge mobile chargés négativement au niveau de l'extrémité de contact de la première région dopée de semi-conducteur de type n (2) et lesdits porteurs de charge mobile chargés positivement au niveau de l'extrémité de contact de la seconde région dopée de semi-conducteur de type p (3).

[Fig. 1]

[Fig. 2]

[Fig. 3]

[Fig. 4]

[Fig. 5]

[Fig. 6]

[Fig. 7]

[Fig. 8]

[Fig. 9]

junction /
absorber

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012006223 A2
- US 9842957 B1
- WO 2016090603 A1
- KR 20150039520 A

**Non-patent literature cited in the description**

- **ROSS** ; **NOZIK**. *Efficiency of hot-carrier solar energy converters*, 1982
- **FERRY et al.** *Challenges, myths, and opportunities in hot carrier solar cells*, 2020
- **ROSENWAKS et al.** *Physical review B*, 1993, vol. 48 (19)
- **KONOVALOV et al.** *Energy Science & Engineering*, 2017, vol. 5 (3), 113-122
- **MARKVART**. *IEEE Journal of Photovoltaics*, 2019, vol. 9 (6), 1614-1624
- **DASHEVSKY et al.** *Journal of Applied Physics*, 2002, vol. 92 (3), 1425-1430
- **LYEO et al.** Mathematics in Biology. *Science*, 06 February 2004, vol. 303 (5659), 816-818
- **KIM et al.** *Appl. Phys. Lett.*, 2007, vol. 90, 043107
- **H. B. CALLEN**. Thermodynamics and an Introduction to Thermostatistics. Wiley, 1985
- **G. HOMM et al.** Seebeck coefficient of n-type (Ga,In) (N,As), (B,Ga, In)As and GaAs. *Appl. Phys. Lett.*, 2008, vol. 93, 042107
- **K. KIM et al.** Thermopower profiling of a silicon p-n junction. *Appl. Phys. Lett.*, 2007, vol. 90, 043107
- **A. F. LOFFE**. Semiconductor Thermoelements and Thermoelectric Cooling. Infosearch Ltd., 1957
- **ZHANG et al.** A review on thermalization mechanisms and prospect absorber materials for the hot carrier solar cells. *Solar Energy Materials & Solar Cells*, 2021, vol. 225, 111073
- **ASAHI et al.** Nitrogendoped titanium dioxide as visible-light-sensitive photocatalyst: designs, developments, and prospects. *Chem. Rev.*, 2014, vol. 19, 9824
- **AHN et al.** Highly Conductive p-type transparent conducting electrode with sulfur-doped copper iodide. *Chem. Mater.*, 2022, vol. 34, 10517
- **BETT et al.** *III-V compounds for solar cell applications*, 1999
- **S. M. SZE** ; **K. NG. KWOK**. Physics of Semiconductor Devices. John Wiley and Sons, 2007
- **T. MARKVART** ; **L. CASTAÑER**. Practical handbook of Photovoltaics. Elsevier, 2003
- **E. NAJAFI et al.** Super-diffusion of excited carriers in Semiconductors. *Nature Com.*, 2017, vol. 8, 15177
- **Q. WENG et al.** Quasiadiabatic electron transport in room temperature nanoelectronic devices induced by hot-phonon bottleneck. *Nature Com.*, 2021, vol. 12, 4752
- **X. WANG et al.** Design of GaAs Solar Cells Operating Close to the Shockley-Queisser Limit. *IEEE J. Photovoltaics*, 2013, vol. 3, 737
- **Y. ROSENWAKS et al.** Hot-carrier cooling in GaAs: Quantum wells versus bulk. *Phys. Rev. B*, 1993, vol. 48, 14675